# EUROPEAN PATENT SPECIFICATION

(11) **EP 0 413 291 B1**
(45) Date of publication and mention of the grant of the patent: **08.03.1995**
(21) Application number: 90115527.5
(22) Date of filing: 13.08.1990
(51) Int. Cl.: C23C 14/35, C23C 14/54, H01J 37/34

(54) **Method and device for sputtering of films**
Verfahren und Vorrichtung zum Sputterauftragen von Filmen
Procédé et dispositif de deposition de films par pulvérisation cathodique

(30) Priority: 14.08.1989 CS 4804/89
(43) Date of publication of application: 20.02.1991
(73) Proprietor: HAUZER HOLDING B.V., NL-5916 PA Venlo (NL)
(72) Inventor: Kadlec, Stanislav, CS-Praha 5 (CS); Musil, Jindrich, CS-Revnice (CS)
(74) Representative: Dipl.-Phys.Dr. Manitz Dipl.-Ing. Finsterwald Dipl.-Ing. Grämkow Dipl.Chem.Dr. Heyn Dipl.Phys. Rotermund Morgan, B.Sc.(Phys.)

(56) References cited:
- EP-A- 0 275 021
- US-A- 3 458 426
- REVIEW OF SCIENTIFIC INSTRUMENTS. vol. 44, no. 6, June 1973, NEWYORK US pages 726 - 731; R. LIMPAECHER ET AL.: 'Magnetic multipole containmentof large uniform collisionless quiescent plasmas.'
- JOURNAL OF APPLIED PHYSICS. vol. 63, no. 6, 15 March 1988,
- NEW YORK US pages 1899 - 1903; A.D. KUYPERS ET AL.: 'A magnetic multipolereactor for high-flux reactive-ion etching.'

## Description

The present invention concerns a method of layer sputtering on substrates with particles sputtered from an electrode surface during glow discharge in a gas or gas mixture under reduced pressure held in a vacuum chamber containing said substrates, a closed tunnel of magnetic field lines being formed above said electrode, said chamber including means for defining a plasma holding space with the aid of a magnetic field, the holding space being bounded by means for forming multipolar magnetic field lines, the vacuum chamber walls being arranged outside the holding space and separated from the holding space by said magnetic field lines.

Furthermore the invention concerns a device for carrying out layer sputtering onto substrates in a vacuum, said device including a vacuum chamber (1) in which a sputtering source electrode (37) and a substrate holder (4) are placed, the vacuum chamber having a wall with a working gas inlet and a vacuum pumping outlet, and an externally located voltage source coupled to the electrode, and a plurality of magnetic field sources (10) is arranged to produce a multipolar magnetic field which forms a plasma containing holding space.

Coating thin layers by cathode sputtering is a well-known process. Usually, cathode sputtering is preferred over other methods of coating layers, such as vacuum evaporation, in that cathode sputtering offers high reproducibility, layer coating in arbitrary directions, such as from top to bottom, and allows mixture and alloy compositions from a sputtered cathode to be transformed into layer form, etc. However, classic diode sputtering is inefficient and time consuming, due to the high gas pressures necessary for maintaining a glow discharge. Consequently, methods and means utilizing a magnetic field for reduction of working pressure during sputtering have been proposed. These systems are based on U.S. Patent No. 2,146,025 issued to Penning (1939). Another solution was proposed in U.S. Patent No. 3,616,450 issued to P. Clarke (1971). In accordance with that patent, the path of electrons in a sputtering device is elongated by a cylindrical hollow anode placed in an axial magnetic field and by a sputtering cathode formed in the shape of a hollow cylinder, accommodated coaxially with the anode, outside the magnetic field. However, a more successful solution was magnetron discharge in accordance with U.S. patents No. 3,878,085 issued to J. Corboni (1975) and No. 4,166,018 issued to J.S. Chapin (1979). In accordance with those patents, a closed tunnel of magnetic field lines of force is formed, the path of electrons in this tunnel is elongated, ionization is increased, and sputtering is accelerated. See also, J.L. Vossen and W. Kern, Thin Film Processes, pp. 76-140 (Academic Press, New York, 1978).

In practice, it is sometimes necessary during layer sputtering that when material is condensing on the substrate, at the same time the substrate must also be bombarded with charged particles of suitable energy, such as positive ions. This method of coating is called ion plating. Before being used with sputtering, ion plating was used with vacuum evaporation. An example is evaporating with an electronic beam in accordance with U.S. patent No. 4,197,175 issued to Noll et al. (1980). Ion plating during magnetron sputtering is well-known from U.S. patent No. 4,116,791 issued to Bizega (1978). A substrate is placed on an electrode which is supplied with a negative voltage relative to the vacuum chamber, while a magnetron cathode is placed opposite the substrate and is also supplied with a negative voltage relative to the vacuum chamber. The biased electrode with substrates thereon attracts ions from the magnetron discharge, and thus ion plating occurs. In accordance with U.S. patent No. 4,426,267 issued to W. Münz et al. (1984), a method and device for coating three-dimensional bodies are provided. In accordance with that method, bodies intended for coating move between two magnetron cathodes having a common glow discharge, in the space between them. It is possible to supply the substrates with negative bias for ion plating.

One drawback of the above-mentioned methods of ion plating during magnetron sputtering is that the ionization current extracted by the biased substrates quickly drops as the distance between the substrate and the magnetron cathode increases. Typically, when the distance between the substrate and the cathode is 20 to 50 mm, the ionization current is too low for successful ion plating. Furthermore, the plasma between the pair of cathodes cannot he sustained if the cathodes are separated by large distances, thus making it impossible to use the above-mentioned methods for ion plating remote or large objects. It is possible to increase the plasma density at greater distances from a magnetron cathode however. One way to do this is by means of arc discharge in a hollow cathode, from which electrons are extracted for plasma ionization. This system is disclosed in U.S. patent No. 4,588,490 to J.J. Cuomo (1986). However, such a solution is complicated and expensive.

A certain increase of the charged particles' current on substrates is observed with a planar magnetron of the "unbalanced" type; see B. Window and N. Savvides, J. Vac. Sci. Technol., A4:196-202 (1986). In this type of magnetron, some magnetic field force lines which radiate from the periphery of the sputtered cathode approach each other and at greater distances recede from each other. Substrates placed in a magnetic field above the cathode are subjected to a greater bombardment by charged particles than with the classic "balanced" magnetron.

It is possible to attain higher ionization currents on substrates than is possible with unbalanced magnetrons by application of a double-sided discharge in accordance with Czechoslovakian author's certificate No. PV 8659-88 of S. Kadlec, J. Musil and W.D. Münz. In this device, there is formed an intense magnetic field between the cathode and the substrates, and the discharge between the cathode, substrate and anode is maintained by processes on the cathode and on the substrates. High induction of the magnetic field concentrated in the space between the cathode and substrates guarantees maintenance of a dense plasma and guarantees that the density of ionization current flowing on the substrates does not drop with increasing cathode distances up to about 200 mm.

A drawback of unbalanced magnetron and double-sided discharge is that the plasma and density of ionization current on the substrates are not sufficiently homogenous across the magnetic field's lines of force. In addition, substrates are inevitably placed directly in the magnetic field and this field is therefore affected by the magnetic properties of substrates. Consequently, it is practically impossible to use the same device for both weak magnetic and ferromagnetic substrates.

It is well known from plasma physics that a relatively dense and homogenous plasma can be maintained using a multipolar magnetic field. See, for example, R. Limpaecher and K.R. Mac Kennzie, Rev. Sci. Instrum., 44:726 (1973). Plasma is generated in such a system by emission of electrons from glowing cathodes and at the same time the plasma is maintained by a multipolar magnetic field formed by permanent magnets placed around the whole chamber oriented with alternating polarity. The purpose is to produce a steady plasma with high spatial homogeneity in the central part thereof where the magnetic field is very low.

Besides plasma generation by emission of electrons there is a well-known method of plasma generation by absorption of microwaves to decompose gases such as SF₆, and use of the decomposition products to etch substrates. French patents Nos. 25-47-961 and 25-47-962 (1984) and No. 25-83-250 (1986) issued to Y. Arnal, J. Pelletier, C. Pomot and M. Pichot disclose methods and devices which teach how to combine such a microwave-generated discharge and multipolar containment, or "holding" to provide a more homogenous and denser plasma, so as to increase the homogeneity of the plasma-produced reactive gas, and provide a more homogenous generation of radicals and therefore an increase of etching homogeneity and anisotropy, as stated in the work of Y. Arnal, et al., Appl. Phys. Lett., 45:132 (1984). However the purpose of multipolar holding as used in the above-mentioned cases is different than for maintaining plasma for ion plating during sputter deposition, where a direct-current glow discharge occurs between anode and sputtered cathode.

In the European Patent Application EP-A-0 275 021 there is described a sputtering process and apparatus for carrying out the same for forming a film over the surface of a substrate. A target formed of the film forming material is held on a sputtering electrode, the substrate being disposed at a predetermined distance and opposite to the target. A cusp magnetic field is produced between the sputtering electrode and the substrate electrode to generate a high-density plasma on the surface of the sputtering electrode. By that the plasma is confined on the target.

In the Journal of applied physics vol. 63, no. 6, 15 March 1988, New York, US pages 1899-1903; A.D. Kupyers et al.: "A magnetic multipole reactor for high-flux reactive-ion etching" there is described a magnetic multipole reactor for high-flux reactive-ion etching. This reactor consists of two coaxial cylinders. By applying a voltage to these cylinders a radial electric field is achieved. For confining the charged particles in a plasma respectively for preventing the electrons from moving directly to the electrodes, a local magnetic field, parallel and close to the plasma boundary is provided, which will reflect charged particles moving outwards. Such fields can be generated by placing permanent magnets with their north and south poles in alternating order along the discharge confining walls.

According to the mentioned document said reactor can also be used for sputtering of SiO₂.

It is an object of the invention to improve a method respectively a device of the above-mentioned kind in that way, that density and homogeneity of ionisation and electron current on substrates is increased.

A method according to the invention solves this problem in the way that the substrates are arranged within the holding space, the electrode forms a cathode above which a closed tunnel of magnetron-type magnetic field lines is formed, said magnetic field lines separate the holding space from an anode being arranged outside the holding space, a plurality of cathodes is arranged around the holding space, having sputtering surfaces with a closed tunnel of magnetron-type magnetic field lines above, each closed tunnel forming part of and being connected with the magnetic field bounding the holding space, the direction of the magnetic field alternates along the boundary of the holding space from positive polarity to negative polarity and vice versa, moving from the edge of the holding space to the centre, the magnetic field intensity drops, and the interaction of the magnetic field and the plasma during the glow discharge between the cathodes and the anode causing the plasma to be held within the holding space so that the substrates and layers growing thereon are bombarded by particles in the plasma.

By a device according to the invention the above problem is solved in the way that the holding space contains the substrates, the electrode forms a cathode above which a closed tunnel of magnetron-type magnetic field lines is formed, an anode is arranged outside the holding space and separated from the holding space by said magnetic field lines, a plurality of cathodes is arranged around the holding space, having sputtering surfaces with magnetic field sources located behind those surfaces, the magnetic field sources producing a closed tunnel of magnetron-type magnetic field lines above the surfaces, each closed tunnel of magnetron-type magnetic filed lines forming part of the magnetic field bounding the holding space.

There are several ways to vary the degree to which the plasma is held in the holding space: by changing the intensity and/or the form of the holding multipolar magnetic field with respect to the anode, the chamber walls, and/or the cathode. These variations change the plasma's density around the substrates and change the energy of the plasma's charged particles. Variation can also be effected by varying the polarity and voltage intensity between the anode and an auxiliary electrode placed in the holding space. There are also several ways to control bombardment of substrates by charged particles: by controlling the potential of the surface of the substrates or of layers growing on the substrates relative to the anode, or by allowing the potential of the substrates or growing layers to float. Due to the difference between the plasma potential and the floating potential, the substrates or layers are bombarded by charged particles, the energy and density of which is controlled by the plasma's holding degree, gas pressure and sputtering discharge output.

A device for carrying out the above-mentioned method comprises a vacuum chamber, in which the cathode of the sputtering source is accommodated, a substrate holder and an anode. In the wall of the vacuum chamber there are means for supply of working gas and for pumping out used gasses. Outside the vacuum chamber, there is a direct-current or high-frequency voltage source, connected between cathode and anode, and magnetic field sources. The substance of the invention is that sources of the magnetic field for forming and maintaining the multipolar magnetic field are placed around the whole holding space containing substrates so that groups of magnetic field sources which have like poles in one direction alternate with adjacent groups of magnetic field sources which have like poles in the opposite direction. The sources of the magnetic field may be placed in one or more locations inside the chamber, in the chamber wall, outside the chamber, or behind the cathode and groups of sources placed behind the cathode are arranged in concentric closed curves for forming at least one closed tunnel of magnetic lines of force above the cathode's surface.

The substrate holder and the anode are electrically connected either by a direct current or high-frequency voltage source, U_{E}, or by a variable resistor, R, which is selectable from zero resistance to infinite resistance. In order to enable changing of the anode's position with regard to the magnetic field, the device is equipped with a sliding anode extension piece made of conductive material, electrically connected with the anode. It is also possible to change the plasma's holding degree so that at least one auxiliary electrode is accommodated in the holding space and outside the chamber is accommodated a direct-current voltage source U_{E}, with one pole connected to the auxiliary electrode and with the other pole connected to the anode.

The present invention teaches the creation of dense and homogenous plasmas on substrates during layer sputtering. It is also possible to attain ion plated layers on substrates, positioned at various distances from the cathode, usually 30 to 500 mm. Densities of ionic current on the substrates usually attain values of 0.1 to 10 mA/cm² with current density on the cathode of 2 to 50 mA/cm² obtainable even with a cathode-substrate separation of 200 mm or more. At the same time, it is possible to attain such a plasma spatial homogeneity that ionization current is constant within a tolerance ±10% with a typical length of 100 to 200 mm, i.e. distance from cathode of from 100 to 250 mm. Such a homogenous ionic bombardment enables the formation of layers such that layers have the desired properties over the entire surface of the substrate even when the substrate is a three-dimensional body. For example, it is possible to form compact titanium nitride layers having microhardnesses from 2,000 kg/mm² to 2,600 kg/mm², where texture, stress, etc., can be controlled by varying the bias level on the substrates, typically from -20 to -150 V. It is possible to create compact titanium nitride layers without an external substrate bias source, by regulating the plasma's holding degree to create a floating potential of, for example, -20 to -45 V. In such a way it is possible to control layer texture from (200) to (111), while stress in these layers is low, from 2 to 3 GPa. One advantage of the method and device is that they allow for a wide range of operating pressures, especially at low pressures down to 2x10⁻² Pa.

A further advantage is the possibility of coating non-conductive layers by means of direct-current sputtering or coating layers on non-conductive substrates with the use of floating substrate potential. The device's primary advantage is that substrates are placed in the space where the magnetic field is weak and therefore it is possible to coat both magnetic and non-magnetic substrates using the same device.

### BRIEF DESCRIPTION OF THE DRAWINGS

Fig. 1A is a longitudinal sectional view taken along lines A-A of Fig. 1B illustrating a first embodiment of a sputtering device;
Fig. 1B is a sectional view taken along lines B-B of Fig. 1A;
Fig. 2 is a longitudinal sectional view similar to Fig. 1A illustrating an alternative embodiment having a rectangular cathode and an anode extension piece;
Figs. 3A and 3B are views similar to Figs 1A and 1B illustrating an embodiment of the invention having four cathodes and auxiliary electrodes;
Figs. 4A-4C are graphs showing certain operating characteristics of the invention; and
Fig. 5 is a graph of ionization current and floating potential vs. overall pressure.

### DESCRIPTION OF THE PREFERRED EMBODIMENTS

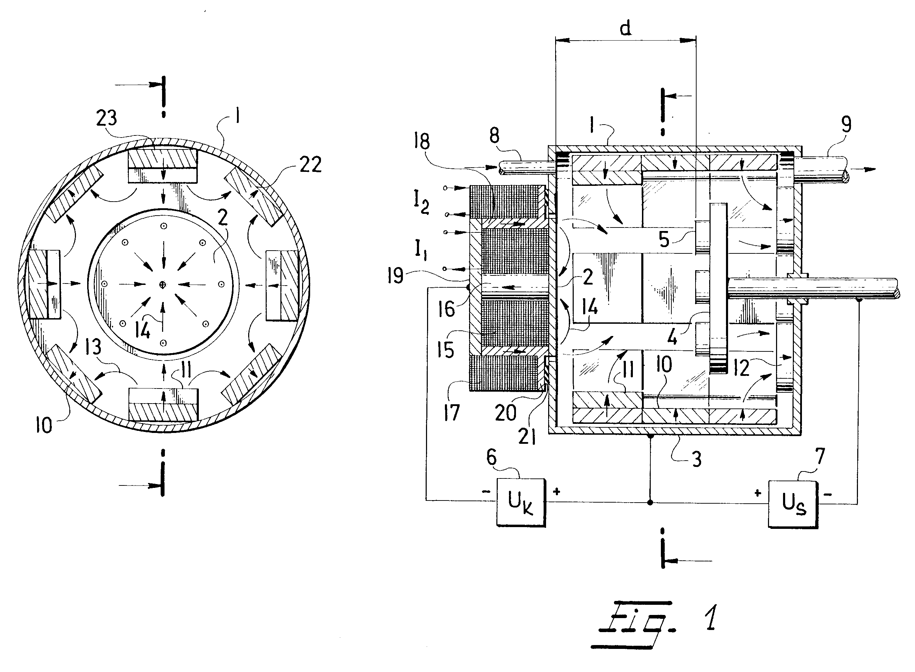

Fig. 1 schematically represents a device equipped with two electromagnets behind a circular cathode. The device consists of chamber 1, which is a vacuum chamber made of a magnetically soft metal and is cylindrical in shape, with its axis oriented horizontally. Chamber 1 also serves as anode 3. Chamber 1 is equipped with inlet 8 which provides working gas and pumping outlet 9. Flush with one vertical wall of chamber 1 and coaxial with it, is a flat circular cathode 2 made of titanium. Circular holder 4 of substrates 5 is fastened coaxial to chamber 1 and opposite cathode 2; holder 4 is adjustably fastened such that the distance between holder 4 and cathode 2 can be varied from 30 to 300 mm. Source 6 of cathode voltage U_{K} and source 7 of substrates voltage U_{S} are placed outside chamber 1. Source 6 of voltage U_{K} is a source of direct-current voltage from zero to 1,000 V and is connected with its negative pole to cathode 2 and its positive pole to chamber 1. Source 7 of direct-current voltage U_{S}, variable from zero to 1,000 V, is connected with its negative pole to conductive holder 4 and its positive pole to chamber 1. Sources of the multipolar magnetic holding field are, in part, permanent magnets 10, 11, 12, and, in part, two electromagnets 15, 17.

As seen in Fig. 1A, permanent magnets 10, 11 are accommodated and fastened on the inner surface of chamber 1 in groups 22, 23 which form an even number of rows, eight are shown in Fig. 1A, parallel with the device's axis. All the magnets in a given group have congruent orientations and have radial directions. The magnets of adjacent groups 22, 23 have opposite polarity orientations. For this purpose, magnets 11 closer to cathode 2 are doubled in one orientation. Permanent magnets 12 are further accommodated on the chamber's inside vertical wall behind the substrates and their poles are oriented parallel with the device's axis and their field is connected with the fields of magnets in groups 22, 23 on the inner surface of chamber 1.

The device is further equipped with two electromagnets for forming a holding magnetic field. The first electromagnet consists of coil 15, connected across current source I₁, placed behind cathode 1 and coaxially with it, and of core 16 made of soft steel, which is inserted into the central cavity of the first coil 15. The second electromagnet consists of the second coil 17, connected across current source I₂, which is placed behind cathode 1 and coaxially with it around the first coil 15. Hollow core 18, made of soft steel in the shape of a cylindrical annulus, fills the space between the first and the second coil and is connected across plate 19, made of soft steel, with core 16. The whole assembly of cathode 2, the first and the second coil 15 and 17 and magnetic circuit 16, 18, 19 are attached across packing and insulating ring 21 by aid of flange 20 on the edge of the circular cut-out in the vertical wall of chamber 1. For clarity, several components are not shown, such as: the sources of currents I₁ and I₂, the gas filling and pumping systems, packing, insulation, vacuum gauges, means for cooling the cathode, chamber and substrates, and means for heating the substrates. If the process of layer sputtering requires it, the device can also include a movable shutter between the cathode and substrates.

The device functions as follows: Chamber 1 is filled through inlet 8 with a working gas or gas mixture, such as a mixture of argon and nitrogen, to a required overall pressure, p_{T}. A glow discharge is then ignited between cathode 2 and chamber 1, which also serves as anode 3. This discharge is conditional and is influenced by the multipolar magnetic holding field lines of force 13, 14 which enclose the holding space where substrates 5 and holder 4 are accommodated. The lines of force of the multipolar field on the boundary of the holding space change direction at various locations owing to the alternating polarities of magnet groups 22, 23. Therefore, moving from the edge of the holding space, to the center, the magnetic field intensity drops quickly. This field pattern applies magnetic pressure to the plasma from the edges toward the center of the holding space, thereby confining a dense plasma.

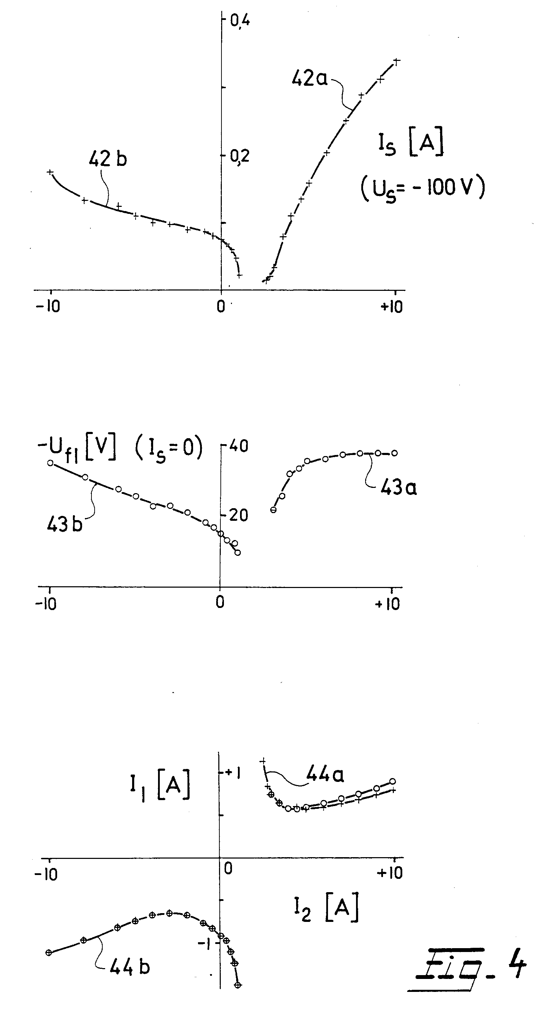

Magnetic induction on the boundary of the holding space is usually 10 mT to 50 mT or even more; in the middle region containing the substrates, it usually ranges from zero to 2 mT. For perfect plasma holding, it is necessary that from the middle region of the holding space to the anode no channel runs with a lower than minimum magnitude of magnetic induction, which is usually from 1 to 10 mT. If such a channel exists, holding is only partial and the density of the plasma is reduced. Also, the discharge stability may be reduced as further described in conjunction with Fig. 4.

A part of the multipolar magnetic holding field is the magnetic field above cathode 2, formed by coils 15 and 16 and magnetic circuit 16, 18, 19, placed behind cathode 2. Current I₁ of coil 15 forms a closed tunnel of lines of force 14 above the cathode and current I₂ of second coil 17 forms a magnetic field, with lines of force emerging from the edge of cathode 2 and connecting with lines of force formed by permanent magnets 11. It is possible to change the shape and intensity of the magnetic field formed by coils 15 and 17 by changing the polarity and magnitude of currents I₁ and I₂, thereby affecting the plasma's holding, as seen from Fig. 4.

Therefore, a dense plasma results from interaction of the glow discharge between cathode 2 and anode 3 with the multipolar magnetic holding field and is maintained in the holding space. Particles from this plasma, especially electrons and positive ions, impinge on the substrates and can affect the properties of growing layers. If the substrates are electrically conductive, it is possible to apply a voltage U_{S} from source 7 to them and thereby change the kind and energy of bombarding particles, and also change further conditions of the layers' growth. A voltage U_{S} from -20 to -100 V is usually sufficient during layer deposition to achieve such effects. In the case of a higher voltage U_{S}, usually from at least -200 to -1,000 V, it is possible to attain ionic etching of substrates 5.

It is also possible to affect properties of layers by changing the distance between the cathode and the substrates. It was found that in a device in accordance with Fig. 1 that during titanium sputtering in argon with pressure p_{T} = 0.1 Pa and with constant cathode discharge, the ionization current Iₛ flowing onto substrates with a bias of U_{S} = -100 V varied only ±10% from its mean value, over cathode-substrate separations ranging from 80 to 220 mm. It is an important advantage of the present method and device, confirming high homogeneity of plasma in the holding space, and can be utilized for affecting properties of layers.

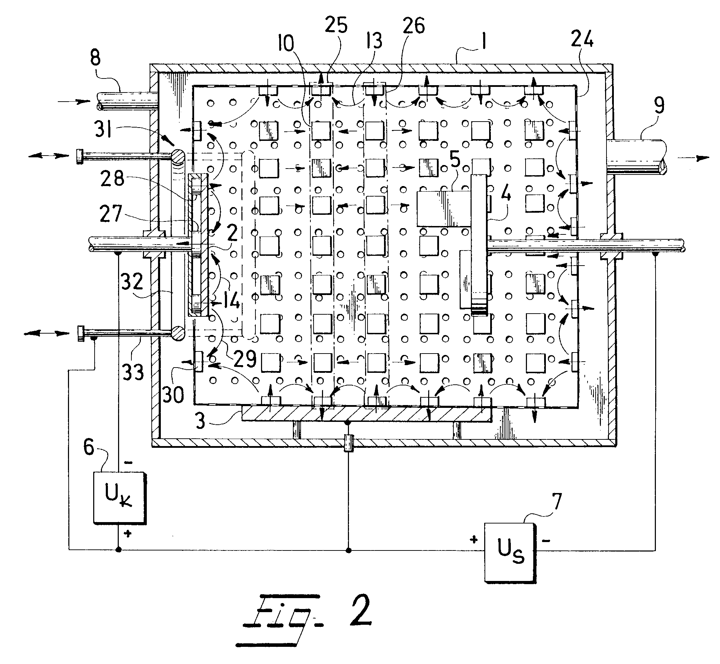

Fig. 2 schematically represents a device equipped with one rectangular cathode and an anode extension piece. Vacuum chamber 1, equipped with inlet 8 for working gas and pumping output 9, has a parallelepiped shape. At the lower wall of chamber 1 and parallel with it, is provided an insulated anode 3, a quadrangular plate made of conductive material. Cathode 2 is placed parallel with one vertical wall of chamber 1 and has a rectangular shape. Opposite cathode 2, and parallel with it, is a flat holder 4 of substrates 5. Cathode voltage source 6, U_{K}, and substrates voltage source 7, U_{S}, are provided outside chamber 1. Sources of the multipolar magnetic holding field are formed by permanent magnets 10 which are partly attached around the holding space on a perforated magnet carrier 24, connected electrically with anode 3, and assembled in groups 25, 26, 30, accommodated in planes parallel with the plane of cathode 2. In these groups 25, 26, 30, all magnets are oriented either toward the chamber or in the opposite direction, while adjacent groups 25, 26 are oriented opposite one another.

Permanent magnets are further placed behind cathode 2 in two groups 27, 28. The first group 27 has a rectangular base and is placed behind the middle part of cathode 2 and the second group 28 is placed behind the perimeter of cathode 2. The orientations of magnets in both groups 27, 28 are mutually opposite, and lines of force 29 of the magnetic field in the second group of magnets 28 are connected with the lines of force in the nearest group 30 of magnets placed on magnet carrier 24. The device is further equipped with movable anode extension piece 31, which is electrically connected to anode 3. Extension piece 31 consists of a rectangular frame 32, with dimensions greater than the dimensions of cathode 2, and of pistons 33, which pass through the wall of chamber 1 behind cathode 2. It is possible to displace extension piece 31 by aid of pistons 33 across lines of force 29 of the magnetic field around cathode 2 into various positions, keeping the plane of frame 32 parallel with the plane of cathode 2. Because of its construction, frame 32 can be behind, before, or even with the plane of cathode 2. For clarity, similar elements are not shown in Fig. 2, in contrast to Fig. 1. Means for cooling anode extension piece 31, anode 3, and magnet carrier 24 are not shown here.

The device in accordance with Fig. 2 functions analogously to the device shown in Fig. 1. However, the magnetic holding field in Fig. 2 is fixed by the layout of permanent magnets 10 used for forming magnet field 14, 29 above cathode. Control of the plasma's holding degree in the holding field can be carried out in this device by movement of anode extension piece 31 across the boundary of the holding space around cathode 2, which would also cross lines of force 29. The highest degree of plasma holding is attained by shifting extension piece 31 out from the holding space and placing it behind the plane of cathode 2. Insertion of extension piece 31 toward the holding space, i.e., into regions of lower magnetic induction causes more electrons and ions from the holding space to impinge on anode extension piece 31, where they recombine, resulting in increased plasma density in the whole holding space, and thus also increasing the plasma density around substrates 5. In such manner, it is possible to regulate the intensity of the bombardment of substrates 5 by particles from the plasma, and thereby regulate the properties of growing layers. Movement of anode extension piece 31, in effect, changes the anode's position with respect to the magnetic field.

It is possible to affect characteristics of the charged particles, such as their number and energy, which bombard the substrates, by holding the substrates' surface at a chosen potential. It is possible to use source 7 of either direct-current or high-frequency voltage U_{S} for biasing conducting substrates and conducting layers. It is necessary to use a source 7 of high-frequency voltage U_{S} in the case of nonconducting substrates and/or nonconducting layers. However, if source U_{S} is disconnected, substrates with growing layers are at floating potential and because of the difference between the plasma potential and the floating potential, growing layers are bombarded by accelerated positive ions and, at the same time, by electrons in the same quantity. It is possible to affect the magnitude of the floating potential and plasma density, which defines the flux density of bombarding particles, firstly by the degree of plasma holding, e.g. by movement of anode extension piece 31, by the magnitude of the gas pressure, and, if need be, by regulating the power of the sputtering discharge by changing the distance between the substrate holders and cathode 2. This method which uses the floating potential of the substrates, has first and foremost the advantage that it is equally suitable for nonconducting and conducting substrates and for conducting and nonconducting layers.

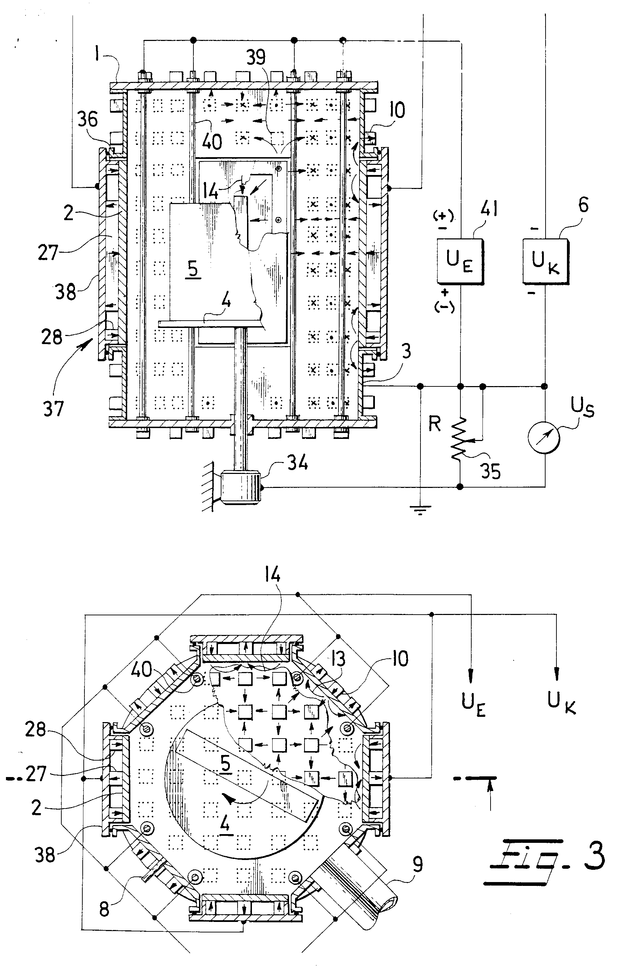

Figs. 3A and 3B represent devices equipped with four cathodes and auxiliary electrodes. Chamber 1 of the device has the shape of an octagon with a vertical axis, is made of nonmagnetic conducting material, such as nonmagnetic stainless steel, and also serves as anode 3. Along the axis of chamber 1 there is accommodated from below a circular holder 4 of substrates 5, which can rotate by means of motor 34, placed under the chamber's bottom. A resistor 35 is connected between substrate holder 4 and chamber 1, resistor 35 being adjustable from zero to infinite resistance. In the four vertical walls of chamber 1, four rectangular cathode assemblies 37 at 90 degree intervals are fixed by flanges 36. Each cathode assembly 37 consists of rectangular cathode 2, magnetically conducting rear plate 38 and permanent magnets 10, arranged in two groups 27, 28, the first of which, group 27, is placed behind the cathode's center and the second, group 28, behind its circumference, by analogy with a device in accordance with Fig. 2. Besides the magnets in cathode assemblies 37, sources of the multipolar magnetic holding field are permanent magnets 10, placed outside chamber 1, in nearly regular fashion on chamber 1, in groups forming vertical rows of similarly oriented magnets and oriented oppositely with respect to adjacent rows. Magnets 10 are accommodated on the exterior wall bases of chamber 1 and oriented in a checkered arrangement. The magnetic field of the magnets at the chamber edges is connected with the magnetic field at the chamber's bases. At the same time, the positions 39 on the inner chamber wall around cathode 2, where in the case of a regular arrangement of magnets 10 there should be placed magnets equally oriented with respect to the second group 28 of magnets behind the cathode 2, are left vacant. The device is further equipped with eight auxiliary electrodes 40, the surfaces of which are advantageously formed of material of cathode 2. These auxiliary electrodes 40 pass through holding space parallel with the axis of chamber 1, while two are always placed near one cathode 2, at opposite edges of each cathode 2. All electrodes 40 are insulatingly led out through the base of chamber 1 to source 41 of voltage U_{E}, placed outside the chamber, which supplies direct-current voltage, e.g. in range -200 to 200 V with respect to chamber 1. For clarity Fig. 3 does not show similar elements as do Figs. 1 and 2. For use at higher power, it is necessary to provide cooling of auxiliary electrodes 40, which are also not shown in Fig. 3.

A function of a device in accordance with Fig. 3 can be analogized to the function of devices according to Figs. 1 and 2. However, in a device in accordance with Fig. 3, the substrates can rotate on holder 4 by means of motor 34. At the same time, four cathodes are sputtered so that layers on substrates grow from all sides simultaneously. The holder 4 of substrates 5 is electrically connected across anode 3 via resistor 35. With R having infinite resistance, substrates are held at floating potential; with R having zero resistance, holder 4 is held at the anode's potential. The resistance of resistor 35 can consequently change the substrates' bias and the current that flows onto them. The degree of plasma holding in the holding space is affected by the polarity and magnitude of U_{E} on auxiliary electrodes 40. A sufficiently high negative voltage with respect to anode 3, e.g. in the range from -20 to -200 V, or higher if need be, is fed to electrodes 40. Electrons from the plasma are repelled by the negative bias of auxiliary electrodes 40 and the degree of plasma holding is high. By changing the voltage U_{E} on electrodes 40 gradually to a positive voltage, e.g. from value of -20 V to a value of +50 V, electrodes 40 act as anodes, i.e. plasma on electrodes 40 recombines and the degree of plasma holding in holding space is thereby reduced. Therefore, the plasma's density around the substrates is reduced and consequently it is possible to affect the quantity of charged particles impinging on substrates.

An important advantage of the device in accordance with Fig. 3 is that uniform rate of layer coating on substrates is attained practically from all directions due to the regular layout of large-size cathodes 2 around substrates 5 and due to rotation of holder 4. This, together with the plasma's homogeneity around the substrates, guaranteed by the multipolar magnetic plasma holding, allows for the creation of homogeneously coated layers on all substrate surfaces. This advantage is very important, especially for layers whose properties strongly depend on deposition rate, energy and density of impinging particles, such as titanium nitride layers needing specific stress and of crystallite orientation characteristics.

Fig. 4A is a graph of the I_{S} (ionization current) vs. I₂ characteristic 42a,b in a device according to Fig. 1 with substrate bias U_{S} = - 100 V. Fig. 4B is a graph of the U_{fl} (substrate floating potential) vs. I₂ characteristic 43a,b with current Iₛ = 0 A. Fig. 4C is a graph of the I₁ vs. I₂ characteristic 44a,b. The following parameters were held constant during the measurement of characteristics 42a,b; 43a,b; and 44a,b: cathode-substrate separation = 200 mm, argon gas pressure (p_{T}) = 0.1 Pa, cathode voltage (U_{K}) = -600 V, cathode current (I_{K}) = 1 A.

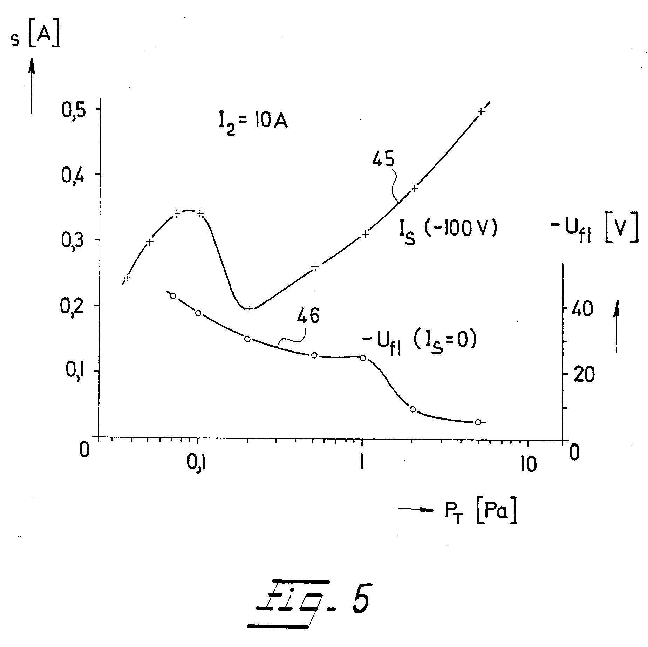

Fig. 5 shows the Iₛ vs. p_{T} characteristic 45 in a device according to Fig. 1, with the substrate voltage U_{S} = -100 V. It also shows U_{fl} vs. p_{T} characteristic 46, with I_{S} = 0 A. Both characteristics 45, 46 were measured with the same constant parameters: cathode-substrate separation (d) = 200 mm, cathode voltage (U_{K}) = -600 V, cathode current (I_{K}) = 1 A and second coil 17 current (I₂) = +10 A.

In Fig. 4, the illustrated characteristics show how it is possible to control the energy and density of particles impinging on substrates 5 in a device according to Fig. 1, by means of varying the multipolar magnetic holding field's shape and intensity. If current I₂ is positive and greater than +2.5 A, shown by interval A in Fig. 4, lines of force 14 emanating from the edge of cathode 2 extend into the holding space as shown in Fig. 1, and these lines of force are repelled by the field of doubled magnets 11. If the polarity of current I₂ is negative or positive but lower than +1 A, shown by interval C in Fig. 4, the lines of force 14 at the edge of cathode 2 flow in the other direction, i.e. from the holding space into cathode 2. In this interval, the lines of force from doubled magnets 11 are connected with the lines of force directed from the edge of cathode 2. In interval B, where current I₂ ranges from +1 A to +2.5 A, the field between the edge of cathode 2 and doubled magnets 11 is very low, lower than about 10 mT. The multipolar magnetic holding field is consequently damaged and the plasma's holding is not only weak, but even under low pressure, e.g. 0.1 Pa, glow discharge does not occur at all, for any arbitrary magnitude of current I₁ into the first coil 15. A stable discharge under low pressure, e.g. lower than 0.2 Pa, requires consequently that the multipolar magnetic holding field be connected with the cathode's field, either parallel as in interval A or antiparallel as in interval C in Fig. 4.

Curves 42a and 42b show that, in both intervals A and C, it is possible to control the flux density of ions bombarding the substrates with constant voltage U_{S} on substrates, e.g. -100 V. Curves 43a and 43b show that even with zero overall ionization current, Iₛ, it is possible to control the floating potential of the substrates U_{fl}, in both intervals A and C. Curves 44a and 44b illustrate that using current I₁ of first coil 15, it is possible to hold the discharge voltage and current at constant values, even though the current I₂ is widely varying. These curves 44a,b show also that it is necessary for the magnetic fields of coils 15, 17 to oppose each other, regardless of the polarity of current I₂.

Curves 44a and 44b are not symmetric with respect to zero current I₂, because magnets 11 are doubled and, consequently, even with I₂ = 0 A, the magnetic multipolar holding field is closed by lines of force radiating from magnets 11 to cathode 2.

The characteristics illustrated in Fig. 5 show the possibility of controlling the quantity and energy of particles which impinge on substrates in the device according to Fig. 1 by means of changing the total pressure, p_{T}. Curve 45, the Iₛ (ionization current) vs. p_{T} characteristic, shows that high ionization currents (Iₛ) containing 20 to 50% of the cathode current (I_{K}) can be extracted on substrates 200 mm from cathode 2, with a voltage U_{S} of only -100 V, over a wide pressure range, at least from 0.04 to 5 Pa. The total pressure, p_{T}, also affects the floating potential of the substrates, U_{fl}, within a typical range of -5 to -45 V, as shown in curve 46. Stable discharge was observed down to a pressure of 2x10⁻² Pa.

### Examples

The method of layer sputtering in accordance with the invention is explained below with reference to examples of titanium nitride layers formed in a device represented in Fig. 1.

### Example 1

Substrates 5 made of high-speed steel placed on holder 4 were heated to a temperature of 500°C at a pressure lower than 10⁻² Pa. Voltage Uₛ = - 600 V was applied to substrates 5 for 120 sec and a voltage U_{K} = -500 V was applied to cathode 2 at an argon pressure of 0.09 Pa for ion-cleaning the substrates and the cathode. Next, titanium nitride layers were sputtered for 90 minutes in a mixture of argon and nitrogen at a total pressure of 0.09 Pa with a cathode voltage U_{K} = - 600 V and cathode current I_{K} = 5 A. Substrates 5 were placed at a distance 200 mm from cathode 2 and a bias U_{S} = 100 V was applied to them. With coil 15 current I₁ = 0.9 A and coil 17 current I₂ = 4 A, the substrates were bombarded during growth of layers largely by ions from the plasma with total current I_{S} = 610 mA.

A layer prepared as described above had a thickness of 3.2 »m and Vickers microhardness of HV = 2,590 ± 90 kg/mm², which shows a compact microstructure of the layer as well as a bright gold color.

Titanium nitride layers prepared by conventional magnetron sputtering without the action of a multipolar magnetic holding field where the distance of the substrates from the cathode is 150 mm, at a total pressure of 5 Pa are red, porous and have microhardness of only HV = 214 kg/mm², which is due to the plasma's low density with respect to the substrates and to a low ionization current of I_{S} = 20 mA at the same bias U_{S} = -100 V.

X-ray analysis of titanium nitride layers prepared by the method according to the present invention under the above-mentioned particular conditions gives the following values of the lattice parameters defined by the (111) planes parallel to the surface of the sample: a₁₁₁ = 0.4299 nm, from planes (200): a₂₀₀ = 0.4258 nm; half-width of lines β₁₁₁ = 0.46°, β₂₀₀ = 0.56°, β₂₂₂ = 1.0°; microstress e = (7.3 ± 1.1) x 10⁻³ and macrostress δ = 6.4 GPa. The texture of the coated layer is thick on the (111) plane parallel to the sample's surface. All these values are very near to values attained with titanium nitride layers coated by arc evaporating or low-voltage electron beam evaporating under similar coating conditions. Except for texture, they are also near the values attained during conventional magnetron coating with substantially shorter cathode-substrate separation, typically 50 mm.

### Example 2

Titanium nitride layers were prepared in the same process as in Example 1, except that the bias on the substrates was U_{S} = -50 V, with texture (220), while other physical properties of layers did not change considerably in comparison with Example 1.

### Example 3

Titanium nitride layers were prepared by the same process as in Example 1, but with source U_{S} disconnected and with floating potential U_{fl} = 31 V with respect to anode 3. The layers had thickness 5.5 »m after a deposition time of 120 min and had a microhardness of HV = 2,070 ± 80 kg/mm², so that they too are compact. X-ray analysis gives the following results: a₁₁₁ = 0.4255 nm, a₂₀₀ = 0.4243 nm; β₁₁₁ = 0.23°, β₂₀₀ = 0.27°, β₂₂₂ = 0.51°; e = (4.0 + 0.5) x 10⁻³, δ = 2.9 GPa. Layers had reduced texture (111) + (200), while relation of corrected reflection intensities I₂₀₀/I₁₁₁ = 1. These properties are unusual compared with titanium nitride coated by other physical methods including conventional sputtering and they show low stresses in the layers and low crystal lattice damage with regard to low energy of bombarding ions and simultaneous bombardment by electrons with sufficient current density. In combination with sufficiently high microhardness, these layers have high adhesion to pads and very useful properties when applied to cutting tools.

### Example 4

Example 4 describes control of layer texture by controlling the magnitude of the floating potential, U_{fl}. The same process was used as in Example 3, but with current I₂ = 10A and I₁ = 2A, the floating potential of substrates, U_{fl}, was increased to -45V and the coated layer had a preferred orientation of (111) with relation I₂₀₀/I₁₁₁ ≐ 0.2. Bias reduction of U_{fl} to -24V was attained by changing currents I₂ to 3.8A and I₁ to 1.6A and changing the preferred orientation to (200) with relation I₂₀₀/I₁₁₁ ≐ 5. Other layer parameters, such as microhardness, stress and grid parameters did not change substantially. It is expected that layers with controlled texture are important for optimally coating cutting tools, having a wide variety of applications.

The method in accordance with the invention can also be used for forming titanium nitride decorative gold layers on nonconducting substrates such as glass or porcelain with the process described in Example 1 modified according to Examples 3 and 4 and with the omission of ion-cleaning. Instead of ion-cleaning, it is alternatively possible to perform a sputtering of a titanium layer from 10 to 200 nm thick in an atmosphere of argon without nitrogen for increased layer adhesion. It is possible to advantageously use for this purpose a device in accordance with Fig. 3 where it is possible to coat layers from all directions uniformly at the same time.

The present invention can be modified in several ways. For example, various types and sizes of substrates can be used depending on what material is used as the coated layer and what properties are desired of the layers. It is also possible to use a number of cathode shapes, such as flat, cylindrical, hollow, conical, etc. Further, it is possible to combine various means for controlling the degree of plasma holding, such as changing the magnetic field, using auxiliary electrodes of various shapes and types, and using sliding extension pieces, connected to the anode or an external voltage source. It is also possible to combine all these elements with various means for voltage control on substrates.

In addition, it is possible to accommodate magnets for forming multipolar magnetic field in various modes, such as orienting magnets off the normal to the chamber's wall, but parallel with it. An important modification is selection of the magnets' orientation at the cathode's edge with regard to enclosing magnets in the chamber. This orientation can be both parallel and antiparallel, while the contained plasma has in both cases various parameters, as shown in Fig. 4, curves 42a and 42b, 43a and 43b.

## Claims

1. A method of layer sputtering on substrates with particles sputtered from an electrode surface during glow discharge in a gas or gas mixture under reduced pressure held in a vacuum chamber containing said substrates, a closed tunnel of magnetic field lines being formed above said electrode, said chamber including means for defining a plasma holding space with the aid of a magnetic field, the holding space being bounded by means for forming multipolar magnetic field lines, the vacuum chamber walls being arranged outside the holding space and separated from the holding space by said magnetic field lines,
**characterized by the fact that**
- the substrates are arranged within the holding space,
- the electrode forms a cathode above which a closed tunnel of magnetron-type magnetic field lines is formed,
- said magnetic field lines separate the holding space from an anode being arranged outside the holding space,
- a plurality of cathodes is arranged around the holding space, having sputtering surfaces with a closed tunnel of magnetron-type magnetic field lines above, each closed tunnel forming part of and being connected with the magnetic field bounding the holding space,
- the direction of the magnetic field alternates along the boundary of the holding space from positive polarity to negative polarity and vice versa,
- moving from the edge of the holding space to the centre thereof, the magnetic field intensity drops, and
- the interaction of the magnetic field and the plasma during the glow discharge between the cathodes and the anode causing the plasma to be held within the holding space so that the substrates and layers growing thereon are bombarded by particles in the plasma.

2. Method in accordance with claim 1,
**characterized by the fact that**
the degree of holding of the plasma in the holding space is controlled by changing the intensity and/or form of the holding magnetic multipolar field with regard to the anode and/or with regard to the chamber walls and/or with regard to the cathode, which changes the plasma density around the substrates and the energy of the plasma's charged particles.

3. Method in accordance with claim 1,
**characterized by the fact that**
the degree of holding of the plasma in the holding space is affected by the polarity and intensity of the potential difference between the anode and an auxiliary electrode passing through the holding space.

4. Method in accordance with claim 1,
**characterized by the fact that**
the surfaces of the substrates and/or layers growing on the substrates is held at a selected potential with regard to the anode potential.

5. Method in accordance with claim 1,
**characterized by the fact that**
the substrates and/or growing layers are charged at a floating potential and, owing to difference between the plasma potential and the floating potential, they are bombarded by charged particles, the energy and density of which are controlled by the holding degree of the plasma, the gas pressure and sputtering discharge output.

6. Device for carrying out layer sputtering onto substrates in a vacuum, said device including a vacuum chamber (1) in which a sputtering source electrode (37) and a substrate holder (4) are placed, the vacuum chamber having a wall with a working gas inlet and a vacuum pumping outlet, and an externally located voltage source coupled to the electrode, and a plurality of magnetic field sources (10) is arranged to produce a multipolar magnetic field which forms a plasma containing holding space,
**characterized by the fact that**
- the holding space contains the substrates (5),
- the electrode (37) forms a cathode (2) above which a closed tunnel of magnetron-type magnetic field lines is formed,
- an anode (3) is arranged outside the holding space and separated from the holding space by said magnetic field lines,
- a plurality of cathodes (2) is arranged around the holding space, having sputtering surfaces with magnetic field sources (10) located behind those surfaces, the magnetic field sources (10) producing a closed tunnel of magnetron-type magnetic field lines above the surfaces, each closed tunnel of magnetron-type magnetic field lines forming part of the magnetic field bounding the holding space, whereby, moving from the edge of the holding space to the centre thereof, the magnetic field intensity drops.

7. Device according to claim 6,
**characterized by the fact,**
that groups (22) of said magnetic field sources (10) have like poles extending in one direction and alternate with adjacent groups (23) of magnetic field sources (10) that have like poles extending in the opposite direction.

8. Device according to claims 6 or 7,
**characterized by the fact,**
that at least some of said cathodes (2) have mutually facing sputtering surfaces.

9. Device according to claim 8,
**characterized by the fact**
that the closed tunnels of magnetron-type magnetic field lines of opposing cathodes (2) have the same magnetic field polarisation.

10. Device according to any of the claims 8 or 9,
**characterized by the fact**
that four cathodes (2) are arranged around the holding space.

11. Device according to any of the claims 6 to 10,
**characterized by the fact that**
the magnetic field sources (10, 11, 12, 15, 17, 27, 28) are placed inside the chamber (1) and/or in the wall of the chamber (1) and/or outside the chamber (1) and/or behind the cathode(s) (2), whilst groups (27, 28) of said magnetic field sources placed behind cathode (2) are arranged in concentric closed curves for forming at least one closed tunnel (14) of magnetic field lines above the cathode's (2) surface.

12. Device according to any of the claims 6 to 11,
**characterized by the fact that**
a source (7) of direct-current or high-frequency voltage U_{S} is connected between the substrate holder (4) and the anode (3).

13. Device according to any of the claims 6 to 12,
**characterized by the fact that**
it includes a sliding anode extension piece (31) made of conductive material, which is electrically connected across the anode.

14. Device according to any of the claims 6 to 13,
**characterized by the fact that**
in the holding space there is accommodated at least one auxiliary electrode (40), and outside the chamber there is placed a direct-current voltage source U_{E} (41), attached with one pole across the auxiliary electrode 840) and with the other pole across the anode (3).

## Patentansprüche

1. Ein Verfahren zum Sputtern von Schichten auf Substraten mit Teilchen, die gesputtert werden von einer Elektrodenoberfläche während einer Glimmentladung in einem Gas oder einer Gasmischung unter reduziertem Druck, der in einer die Substrate enthaltenden Vakuumkammer herrscht, wobei ein geschlossener Tunnel von Magnetfeldlinien über der Elektrode gebildet wird, die Kammer Mittel zum Definieren eines Plasmahalteraumes mit Hilfe eines Magnetfeldes umfaßt, der Halteraum durch Mittel zum Bilden multipolarer Magnetfeldlinien begrenzt ist und die Vakuumkammerwände außerhalb des Halteraumes angeordnet und von dem Halteraum durch die Magnetfeldlinien getrennt sind,
**dadurch gekennzeichnet, daß**
- die Substrate innerhalb des Halteraumes angeordnet werden,
- die Elektrode eine Kathode bildet, über der ein geschlossener Tunnel von Magnetfeldlinien vom Magnetrontyp gebildet wird,
- die Magnetfeldlinien den Halteraum von einer Anode trennen, die außerhalb des Halteraumes angeordnet ist,
- eine Vielzahl von Kathoden um den Halteraum herum angeordnet wird, welche Sputteroberflächen mit einem geschlossenen Tunnel von Magnetfeldlinien vom Magnetrontyp darüber aufweisen, wobei jeder geschlossene Tunnel einen Teil des den Halteraum begrenzenden Magnetfeldes bildet und mit diesem gekoppelt ist,
- die Richtung des Magnetfeldes entlang der Grenze des Halteraumes von positiver Polarität zu negativer Polarität und umgekehrt alterniert,
- die Magnetfeldintensität vom Rand des Halteraumes zu dessen Zentrum abfällt, und
- die Wechselwirkung des Magnetfeldes und des Plasmas während der Glimmentladung zwischen den Kathoden und der Anode bewirkt, daß das Plasma innerhalb des Halteraumes gehalten wird, so daß die Substrate und die darauf wachsenden Schichten mit Teilchen in dem Plasma beschossen werden.

2. Verfahren nach Anspruch 1,
dadurch gekennzeichnet,
daß der Grad des Haltens des Plasmas im Halteraum durch Ändern der Intensität und/oder der Form des haltenden magnetischen multipolaren Feldes bezüglich der Anode und/oder bezüglich der Kammerwände und/oder bezüglich der Kathode gesteuert wird, wodurch die Plasmadichte um die Substrate herum und die Energie der geladenen Teilchen des Plasmas geändert werden.

3. Verfahren nach Anspruch 1,
dadurch gekennzeichnet,
daß der Grad des Haltens des Plasmas im Halteraum von der Polarität und der Intensität der Potentialdifferenz zwischen der Anode und einer Hilfselektrode beeinflußt wird, die durch den Halteraum verläuft.

4. Verfahren nach Anspruch 1,
dadurch gekennzeichnet,
daß die Oberflächen der Substrate und/oder der auf den Substraten wachsenden Schichten auf einem ausgewählten Potential bezüglich des Anodenpotentials gehalten werden.

5. Verfahren nach Anspruch 1,
dadurch gekennzeichnet,
daß die Substrate und/oder wachsenden Schichten auf ein schwebendes Potential geladen und aufgrund einer Differenz zwischen dem Plasmapotential und dem schwebenden Potential mit geladenen Teilchen beschossen werden, deren Energie und Dichte durch den Haltegrad des Plasmas, den Gasdruck und den Ausgang der Sputterentladung gesteuert werden.

6. Vorrichtung zum Ausführen des Sputterns von Schichten auf Substrate in einem Vakuum, wobei die Vorrichtung eine Vakuumkammer (1) aufweist, in der eine Sputterquellenelektrode (37) und ein Substrathalter (4) angeordnet sind, die Vakuumkammer eine Wand mit einem Arbeitsgaseinlaß und einem Vakuumpumpauslaß und eine extern angeordnete Spannungsquelle aufweist, die an die Elektrode gekoppelt ist, und eine Vielzahl von Magnetfeldquellen (10) angeordnet ist, um ein multipolares Magnetfeld zu erzeugen, das einen Plasma enthaltenden Halteraum bildet,
**dadurch gekennzeichnet, daß**
- der Halteraum die Substrate (5) enthält,
- die Elektrode (37) eine Kathode (2) bildet, über der ein geschlossener Tunnel von Magnetfeldlinien vom Magnetrontyp gebildet ist,
- eine Anode (3) außerhalb des Halteraumes angeordnet und von dem Halteraum durch die Magnetfeldlinien getrennt ist,
- eine Vielzahl von Kathoden (2) um den Halteraum herum angeordnet ist, die Sputteroberflächen mit Magnetfeldquellen (10) aufweisen, die hinter diesen Oberflächen angeordnet sind, wobei die Magnetfeldquellen (10) einen geschlossenen Tunnel von Magnetfeldlinien vom Magnetrontyp über den Oberflächen erzeugen und jeder geschlossene Tunnel von Magnetfeldlinien vom Magnetrontyp einen Teil des den Halteraum begrenzenden Magnetfeldes bildet, wodurch die Magnetfeldintensität vom Rand des Halteraumes zu dessen Zentrum abfällt.

7. Vorrichtung nach Anspruch 6,
dadurch gekennzeichnet,
daß Gruppen (22) der Magnetfeldquellen (10) gleiche Pole aufweisen, die sich in der einen Richtung erstrecken, und abwechseln mit benachbarten Gruppen (23) von Magnetfeldquellen (10), die gleiche Pole aufweisen, die sich in der entgegengesetzten Richtung erstrecken.

8. Vorrichtung nach Anspruch 6 oder 7,
dadurch gekennzeichnet,
daß wenigstens einige der Kathoden (2) gegenseitig zugewandte Sputteroberflächen aufweisen.

9. Vorrichtung nach Anspruch 8,
dadurch gekennzeichnet,
daß die geschlossenen Tunnel von Magnetfeldlinien vom Magnetrontyp gegenüberliegender Kathoden (2) die gleiche Magnetfeldpolarisation aufweisen.

10. Vorrichtung nach einem der Ansprüche 8 oder 9,
dadurch gekennzeichnet,
daß vier Kathoden (2) um den Halteraum herum angeordnet sind.

11. Vorrichtung nach einem der Ansprüche 6 bis 10,
dadurch gekennzeichnet,
daß die Magnetfeldquellen (10, 11, 12, 15, 17, 27, 28) innerhalb der Kammer (1) und/oder in der Wand der Kammer (1) und/oder außerhalb der Kammer (1) und/oder hinter der Kathode/den Kathoden (2) angeordnet sind, während Gruppen (27, 28) der Magnetfeldquellen, die hinter der Kathode (2) angeordnet sind, in konzentrischen geschlossenen Kurven zur Ausbildung wenigstens eines geschlossenen Tunnels (14) von Magnetfeldlinien über der Oberfläche der Kathode (2) angeordnet sind.

12. Vorrichtung nach einem der Ansprüche 6 bis 11,
dadurch gekennzeichnet,
daß eine Quelle (7) einer Gleichstrom- oder Hochfrequenzspannung U_{S} zwischen den Substrathalter (4) und die Anode (3) geschaltet ist.

13. Vorrichtung nach einem der Ansprüche 6 bis 12,
dadurch gekennzeichnet,
daß sie ein Gleitanodenerweiterungsstück (31) aus leitfähigem Material umfaßt, das elektrisch über die Anode geschaltet ist.

14. Vorrichtung nach einem der Ansprüche 6 bis 13,
dadurch gekennzeichnet,
daß in dem Halteraum wenigstens eine Hilfselektrode (40) untergebracht und außerhalb der Kammer eine Gleichstromspannungsquelle U_{E} (41) angeordnet ist, die mit dem einen Pol über die Hilfselektrode (40) und mit dem anderen Pol über die Anode (3) angebracht ist.

## Revendications

1. Procédé de pulvérisation d'une couche sur des substrats avec des particules pulvérisées à partir d'une surface d'électrode durant une décharge luminescente dans un gaz ou un mélange gazeux sous pression réduite maintenu dans une chambre à vide contenant lesdits substrats, un tunnel fermé de lignes de champ magnétique étant formé au-dessus de ladite électrode, ladite chambre comprenant des moyens destinés à définir un espace de maintien d'un plasma à l'aide d'un champ magnétique, l'espace de maintien étant délimité par des moyens pour former des lignes de champ magnétique multipolaires, les parois de la chambre à vide étant agencées en dehors de l'espace de maintien et étant séparées de l'espace de maintien par les lignes du champ magnétique,
caractérisé par le fait que
- les substrats sont agencés à l'intérieur de l'espace de maintien,
- l'électrode forme une cathode au-dessus de laquelle un tunnel fermé de lignes de champ magnétique du type magnétron est formé, lesdites lignes de champ magnétique séparent l'espace de maintien d'une anode agencée à l'extérieur de l'espace de maintien,
- plusieurs cathodes sont agencées autour de l'espace de maintien, présentant des surfaces de pulvérisation surmontées par un tunnel fermé constitué de lignes de champ magnétique du type magnétron, chaque tunnel fermé formant une partie du champ magnétique délimitant l'espace de maintien et étant connecté à ce champ magnétique,
- le sens du champ magnétique alterne le long de la limite de l'espace de maintien, d'une polarité positive à une polarité négative et vice versa,
- en se déplaçant à partir du bord de l'espace de maintien vers son centre, l'intensité du champ magnétique chute, et
- l'interaction du champ magnétique et du plasma pendant la décharge luminescente entre les cathodes et l'anode amenant le plasma à être maintenu dans l'espace de maintien afin que les substrats et les couches croissant sur lui soient bombardés par des particules dans le plasma.

2. Procédé selon la revendication 1,
caractérisé par le fait que
le degré de maintien du plasma dans l'espace de maintien est commandé par une variation de l'intensité et/ou la forme du champ multipolaire magnétique de maintien par rapport à l'anode et/ou par rapport aux parois de la chambre et/ou par rapport à la cathode, ce qui fait varier la densité du plasma autour des substrats et l'énergie des particules chargées du plasma.

3. Procédé selon la revendication 1,
caractérisé par le fait que
le degré de maintien du plasma dans l'espace de maintien est affecté par la polarité et l'intensité de la différence de potentiel entre l'anode et une électrode auxiliaire passant à travers l'espace de maintien.

4. Procédé selon la revendication 1,
caractérisé par le fait que
les surfaces des substrats et/ou des couches croissant sur les substrats sont maintenues à un potentiel choisi par rapport au potentiel d'anode.

5. Procédé selon la revendication 1,
caractérisé par le fait que
les substrats et/ou les couches croissantes sont chargées à un potentiel flottant et, du fait de la différence entre le potentiel du plasma et le potentiel flottant, ils sont bombardés par des particules chargées dont l'énergie et la densité sont commandées par le degré de maintien du plasma, la pression gazeuse et la puissance de décharge de pulvérisation.

6. Dispositif pour exécuter une pulvérisation de couches sur des substrats sous vide, ledit dispositif comprenant une chambre à vide (1) dans laquelle une électrode (37) de source de pulvérisation et un support (4) de substrat sont placés, la chambre à vide ayant une paroi présentant une entrée de gaz de travail et une sortie de pompage de vide, et une source de tension placée extérieurement et couplée à l'électrode, et plusieurs sources (10) de champ magnétique sont agencées pour produire un champ magnétique multipolaire qui forme un espace de maintien contenant un plasma,
caractérisé par le fait que
- l'espace de maintien contient les substrats (5),
- l'électrode (37) forme une cathode (2) au-dessus de laquelle un tunnel fermé de ligne de champ magnétique du type magnétron est formé,
- une anode (3) est agencée à l'extérieur de l'espace de maintien et est séparée de l'espace de maintien par lesdites lignes de champ magnétique,
- plusieurs cathodes (2) sont agencées autour de l'espace de maintien, ayant des surfaces de pulvérisation en arrière desquelles se trouvent des sources (10) de champ magnétique, les sources (10) de champ magnétique produisant un tunnel fermé de lignes de champ magnétique du type magnétron au-dessus des surfaces, chaque tunnel fermé des lignes de champ magnétique du type magnétron formant une partie du champ magnétique délimitant l'espace de maintien, grâce à quoi, en se déplaçant depuis le bord de l'espace de maintien vers son centre, l'intensité du champ magnétique chute.

7. Dispositif selon la revendication 6,
caractérisé par le fait
que les groupes (22) desdites sources (10) de champ magnétique ont des pôles identiques s'étendant dans un sens et alternent avec des groupes adjacents (23) de source (10) de champ magnétique qui ont des pôles identiques s'étendant dans le sens opposé.

8. Dispositif selon la revendication 6 ou 7,
caractérisé par le fait,
qu'au moins certaines desdites cathodes (2) ont des surfaces de pulvérisation mutuellement opposées.

9. Dispositif selon la revendication 8,
caractérisé par le fait que
que les tunnels fermés des lignes de champ magnétique du type magnétron de cathodes opposées (2) ont la même polarisation de champ magnétique.

10. Dispositif selon l'une des revendications 8 et 9,
caractérisé par le fait
que quatre cathodes (2) sont agencées autour de l'espace de maintien.

11. Dispositif selon l'une quelconque des revendications 6 à 10,
caractérisé par le fait que
les sources (10, 12, 15, 17, 27, 28) de champ magnétique sont placées à l'intérieur de la chambre (1) et/ou dans la paroi de la chambre (1) et/ou à l'extérieur de la chambre (1) et/ou en arrière de la cathode ou des cathodes (2), tandis que des groupes (27, 28) desdites sources de champ magnétique placées en arrière de la cathode (2) sont agencés en courbes fermées concentriques pour former au moins un tunnel fermé (14) de lignes de champ magnétique au-dessus de la surface de la cathode (2).

12. Dispositif selon l'une quelconque des revendications 10 à 11,
caractérisé par le fait que
une source (7) de tension continue ou à haute fréquence (U_{S}) est connectée entre le support (4) du substrat et l'anode (3).

13. Dispositif selon l'une quelconque des revendications 6 à 12,
caractérisé par le fait que
il comprend une pièce d'extension coulissante (31) d'anode formée d'une matière conductrice, qui est connectée électriquement à l'anode.

14. Dispositif selon l'une quelconque des revendications 6 à 13,
caractérisé par le fait que
l'espace de maintien loge au moins une électrode auxiliaire (40), et une source U_{E} (41) de tension continue est placée à l'extérieur de la chambre, et est reliée par un pôle à l'électrode auxiliaire (40) et par l'autre pôle à l'anode (3).
